# EUROPEAN PATENT APPLICATION

(11) **EP 4 610 682 A2**
(43) Date of publication of application: **03.09.2025**
(21) Application number: 25159002.2
(22) Date of filing: 20.02.2025
(51) Int. Cl.: G01R 33/00, G01R 33/09

(54) **MAGNETIC SENSOR**

(30) Priority: 28.02.2024 JP 2024028685
(71) Applicant: TDK Corporation, Tokyo 103-6128 (JP)
(72) Inventor: LIN, Chengbin, Tokyo, 103-6128 (JP); OKAWA, Shuichi, Tokyo, 103-6128 (JP); KAMI, Masafumi, Tokyo, 103-6128 (JP)
(74) Representative: Epping - Hermann - Fischer

(57) **Abstract**

Disclosed herein is a magnetic sensor that includes sensor chip having a magnetosensitive element, first and second compensation coils configured to generate a canceling magnetic field based on an output signal from the magnetosensitive element, a first switch connected in series to the first compensation coil, a control circuit configured to periodically turn on/off the first switch, and a detection circuit configured to detect a compensation current flowing through the second compensation coil.

## Description

### BACKGROUND OF THE ART

### --Field of the Art

The present disclosure relates to a magnetic sensor and, more particularly, to a magnetic sensor capable of detecting a magnetic field in a low frequency region with high sensitivity.

### --Description of Related Art

Magnetic sensors using a magnetosensitive element are now used in various fields. In order for magnetic sensors to detect an extremely weak magnetic field, they need to have a high S/N ratio. As a factor that reduces the S/N ratio of a magnetic sensor, 1/f noise can be cited. The 1/f noise becomes more conspicuous as the frequency component of a magnetic field to be measured becomes lower, so that it is important to reduce the 1/f noise for high-sensitivity detection of a magnetic field in a low frequency region of 1 kHz or less, for example.

JP-T-2020-522696 discloses a magnetic sensor having reduced 1/f noise. This magnetic sensor periodically saturates a magnetosensitive element using a modulator to reduce the 1/f noise.

However, the magnetic sensor described in JP-T-2020-522696 has a problem that it requires a large current to saturate a magnetosensitive element.

### SUMMARY

The present disclosure describes a technology for reducing, in a magnetic sensor capable of detecting a magnetic field in a low frequency region with high sensitivity, the amount of current required for modulation.

A magnetic sensor according to an aspect of the present invention includes: a sensor chip having a magnetosensitive element; first and second compensation coils generating a canceling magnetic field based on an output signal from the magnetosensitive element; a first switch connected in series to the first compensation coil; a control circuit periodically turning on/off the first switch; and a detection circuit detecting a compensation current flowing through the second compensation coil.

According to the present disclosure, a technology for reducing, in a magnetic sensor capable of detecting a magnetic field in a low frequency region with high sensitivity, the amount of current required for modulation can be provided.

### BRIEF DESCRIPTION OF THE DRAWINGS

The above features and advantages of the present disclosure will be more apparent from the following description of some embodiments taken in conjunction with the accompanying drawings, in which:
FIG. 1 is a schematic perspective view illustrating the outer appearance of a magnetic sensor 1 according to a first embodiment of the present disclosure;
FIG. 2 is a schematic perspective view of the sensor chip 100;
FIG. 3 is a schematic plan view of the sensor chip 100;
FIG. 4 is a schematic cross-sectional view taken along the line A-A in FIG. 3;
FIG. 5 is a circuit diagram of the magnetic sensor 1;
FIG. 6 is a graph for explaining the effect of the magnetic sensor 1;
FIG. 7 is a circuit diagram of a magnetic sensor 2 according to a second embodiment of the present disclosure;
FIG. 8 is a schematic perspective view illustrating the outer appearance of a magnetic sensor 3 according to a third embodiment of the present disclosure; and
FIG. 9 is a schematic perspective view illustrating the outer appearance of a magnetic sensor 4 according to a fourth embodiment of the present disclosure.

### DETAILED DESCRIPTION OF THE EMBODIMENTS

Some embodiments of the present disclosure will be explained below in detail with reference to the accompanying drawings.

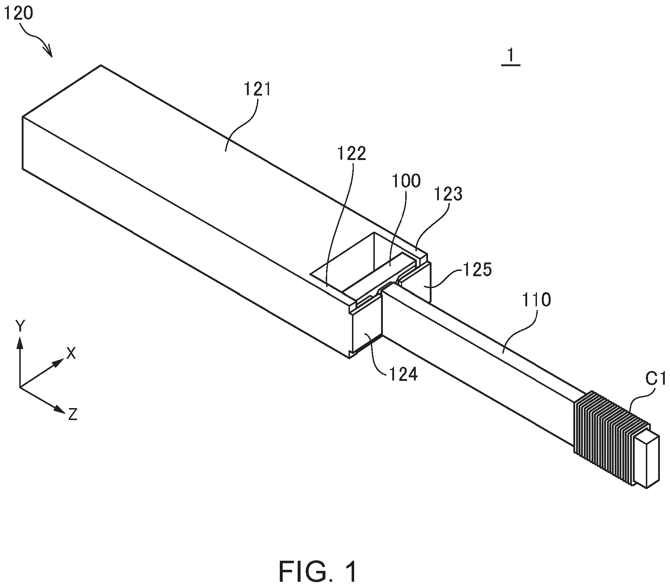

FIG. 1 is a schematic perspective view illustrating the outer appearance of a magnetic sensor 1 according to a first embodiment of the present disclosure.

As illustrated in FIG. 1, the magnetic sensor 1 according to the first embodiment includes a sensor chip 100 having a magnetosensitive element, magnetic field collecting bodies 110 and 120 for collecting a magnetic field to the magnetosensitive element provided in the sensor chip 100, and a compensation coil C1 wound around the magnetic field collecting body 110. The magnetic field collecting bodies 110 and 120 are each a block made of a high permeability material such as ferrite. The magnetic field collecting body 110 has a bar-like shape elongated in the Z-direction, and the end portion thereof in the negative Z-direction faces the sensor chip 100.

The magnetic field collecting body 110 is wound with the compensation coil C1 having its axis extending in the Z-direction. The magnetic field collecting body 120 has a main body part 121 elongated in the Z-direction, a pair of protruding parts 122 and 123 protruding, in the positive Z-direction, from the positive Z-direction end portion of the main body part 121 and having a thickness in the X-direction smaller than that of the main body part 121, an overhung part 124 protruding, in the positive X-direction, from the positive Z-direction end portion of the protruding part 122, and an overhung part 125 protruding, in the negative X-direction, from the positive Z-direction end portion of the protruding part 123. The sensor chip 100 is disposed in a space surrounded by the main body part 121, protruding parts 122 and 123, and overhung parts 124 and 125.

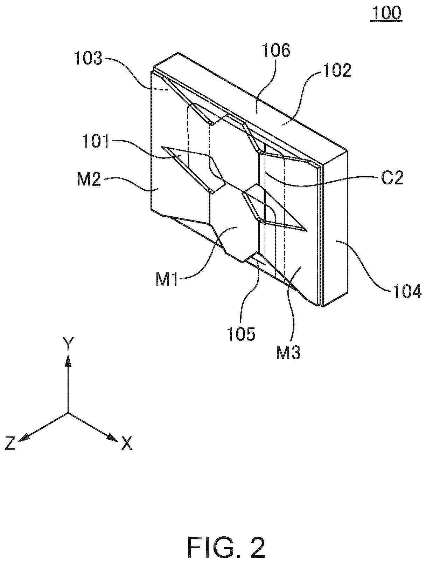

FIG. 2 is a schematic perspective view of the sensor chip 100.

As illustrated in FIG. 2, the sensor chip 100 has an element formation surface 101, a back surface 102, and side surfaces 103, 104, 105, and 106. The element formation surface 101 and back surface 102 constitute the XY surface and positioned on the mutually opposite sides. The side surfaces 103 and 104 constitute the YZ surface and positioned on the mutually opposite sides. The side surfaces 105 and 106 constitute the XZ surface and positioned on the mutually opposite sides. There are formed, on the element formation surface 101 of the sensor chip 100, magnetosensitive elements (to be described later) and magnetic layers M1 to M3 (to be described later).

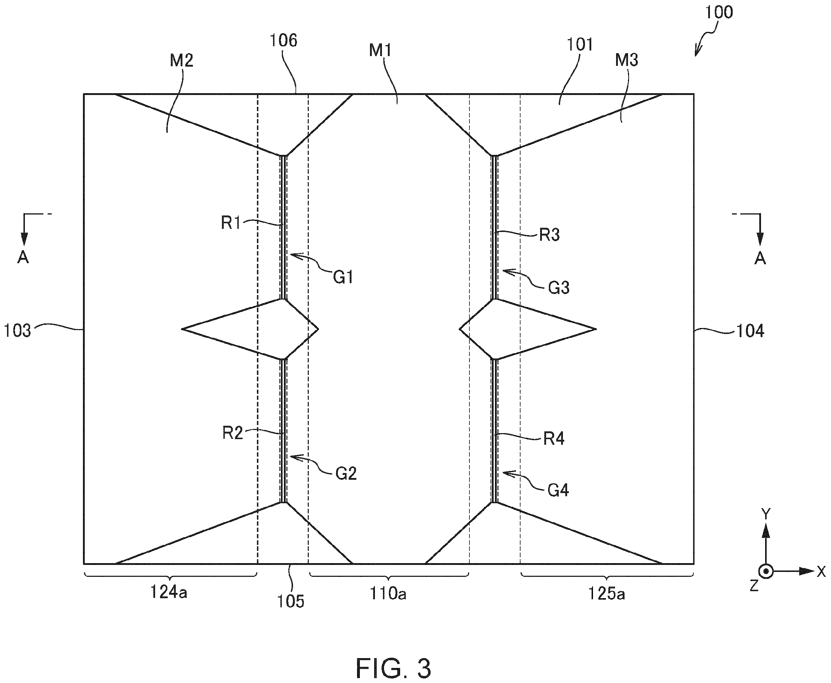

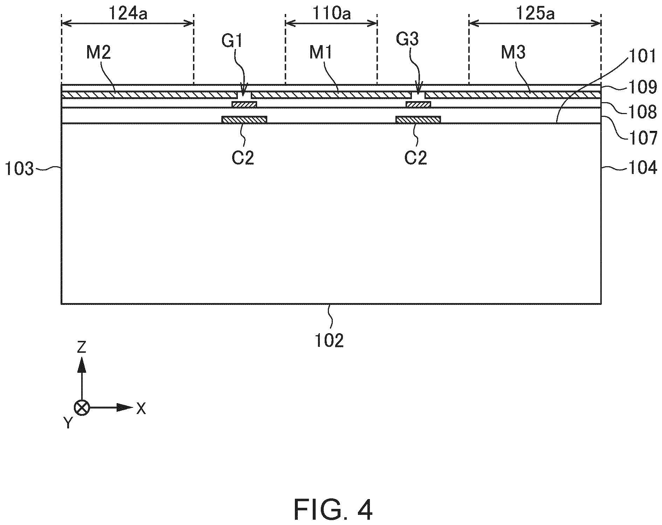

FIG. 3 is a schematic plan view of the sensor chip 100, and FIG. 4 is a schematic cross-sectional view taken along the line A-A in FIG. 3.

As illustrated in FIGS. 3 and 4, four magnetosensitive elements R1 to R4 are formed on the element formation surface 101 of the sensor chip 100. The magnetosensitive elements R1 to R4 are not particularly limited in type as long as they are elements whose electric resistance varies depending on the direction of magnetic flux and may be, for example, an MR element. The fixed magnetization directions of the magnetosensitive elements R1 to R4 are the same direction (for example, positive X-direction). The magnetosensitive elements R1 to R4 are formed on the surface of an insulating layer 107 covering the element formation surface 101. The magnetosensitive elements R1 to R4 are covered with an insulating layer 108, on the surface of which magnetic layers M1 to M3 made of permalloy or the like are formed. The magnetic layers M1 to M3 are covered with an insulating layer 109. The magnetic layer M1 is disposed at substantially the center of the element formation surface 101 in the X-direction. The magnetic layers M2 and M3 are disposed at both sides of the element formation surface 101 in the X-direction so as to sandwich the magnetic layer M1 in the X-direction.

The magnetic layers M1 and M2 form two gaps G1 and G2 each having a width in the X-direction and extending in the Y-direction. The gaps G1 and G2 are at the same X-direction position and arranged in the Y-direction. The magnetic layers M1 and M3 form two gaps G3 and G4 having a width in the X-direction and extending in the Y-direction. The gaps G3 and G4 are at the same X-direction position and arranged in the Y-direction. The gaps G1 and G3 are arranged in the X-direction, and the gaps G2 and G4 are arranged in the X-direction. The magnetosensitive elements R1 to R4 are disposed at positions overlapping the gaps G1 to G4, respectively, in a plan view (as viewed in the Z-direction). With this configuration, magnetic fields in the X-direction passing through respective magnetic gaps G1 to G4 are applied respectively to the magnetosensitive elements R1 to R4.

In FIGS. 3 and 4, reference numeral 110a denotes an area covered in the Z-direction with the XY surface of the magnetic field collecting body 110 positioned at one end in the Z-direction, and reference numerals 124a and 125a respectively denote areas covered in the Z-direction with the overhung parts 124 and 125 of the magnetic field collecting body 120. The side surface 103 of the sensor chip 100 is covered with the protruding part 122 of the magnetic field collecting body 120 in the X-direction, and the side surface 104 of the sensor chip 100 is covered with the protruding part 123 of the magnetic field collecting body 120 in the X-direction. The back surface 102 of the sensor chip 100 is covered with the main body part 121 of the magnetic field collecting body 120.

The areas 110a, 124a, and 125a respectively overlap the magnetic layers M1 to M3. Thus, the magnetic layer M1 is covered with the magnetic field collecting body 110 in the Z-direction, the magnetic layer M2 is covered with the overhung part 124 of the magnetic field collecting body 120 in the Z-direction, and the magnetic layer M3 is covered with the overhung part 125 of the magnetic field collecting body 120 in the Z-direction. Then, a magnetic field in the Z-direction (detection-target magnetic field) is collected by the magnetic field collecting body 110 and applied to the magnetic layer M1 through the magnetic field collecting body 110. The magnetic field thus applied to the magnetic layer M1 is curved in the positive and negative X-directions in the magnetic layer M1. Magnetic flux components curved in the negative X-direction in the magnetic layer M1 are supplied to the magnetic layer M2 through the gaps G1 and G2 and then flow to the overhung part 124, protruding part 122, and main body part 121 of the magnetic field collecting body 120. At this time, a part of the magnetic flux that passes through the gaps G1 and G2 in the negative X-direction is applied to the magnetosensitive elements R1 and R2. On the other hand, magnetic flux components curved in the positive X-direction in the magnetic layer M1 are supplied to the magnetic layer M3 through the gaps G3 and G4 and then flow to the overhung part 125, protruding part 123, and main body part 121 of the magnetic field collecting body 120. At this time, a part of the magnetic flux that passes through the gaps G3 and G4 in the positive X-direction is applied to the magnetosensitive elements R3 and R4.

The magnetic field collecting body 120 need not necessarily have the overhung parts 124 and 125; however, covering the magnetic layers M2 and M3 respectively with the overhung parts 124 and 125 makes it possible to significantly reduce a magnetic resistance between the magnetic field collecting bodies 110 and 120. Further, even when the overhung parts 124 and 125 are absent, it is possible to reduce the magnetic resistance between the magnetic field collecting bodies 110 and 120 by covering the side surfaces 103 and 104 of the sensor chip 100 respectively with the protruding parts 122 and 123. Furthermore, it is possible to efficiently apply a magnetic field in the Z-direction (detection-target magnetic field) to the magnetosensitive elements R1 to R4 by covering the back surface 102 of the sensor chip 100 with the main body part 121 of the magnetic field collecting body 120.

As illustrated in FIGS. 2 and 4, a compensation coil C2 is provided in the sensor chip 100. For example, the compensation coil C2 is disposed at a position overlapping the magnetosensitive elements R1 to R4. When a current flows through the compensation coil C2, a canceling magnetic field is applied to the magnetosensitive elements R1 to R4. In the example illustrated in FIG. 4, the compensation coil C2 is provided on the element formation surface 101. Since the compensation coil C2 is thus integrated in the sensor chip 100, the distance between the compensation coil C2 and the magnetosensitive elements R1 to R4 is significantly smaller than the distance between the compensation coil C1 and the magnetosensitive elements R1 to R4. However, the compensation coil C2 need not necessarily be disposed at a position overlapping the magnetosensitive elements R1 to R4 and may be wound in the magnetic layers M2 and M3, for example. Even in this case, the distance between the compensation coil C2 and the magnetosensitive elements R1 to R4 is significantly smaller than the distance between the compensation coil C1 and the magnetosensitive elements R1 to R4.

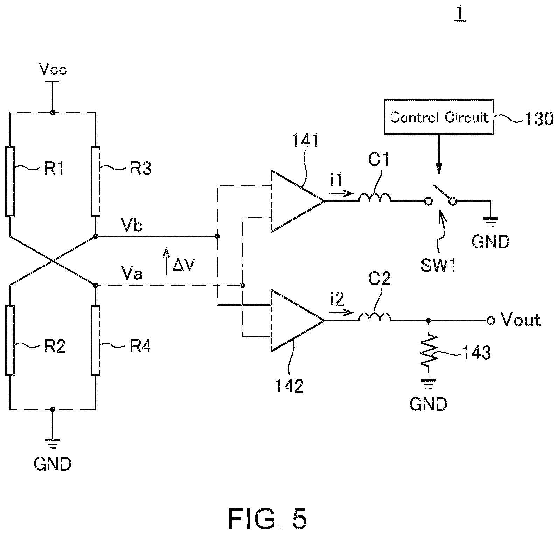

FIG. 5 is a circuit diagram of the magnetic sensor 1 according to the first embodiment.

As illustrated in FIG. 5, the magnetosensitive elements R1 to R4 are bridge-connected between a power supply Vcc and a ground GND. That is, the magnetosensitive elements R1 and R4 are connected in series between the power supply Vcc and the ground GND, and the magnetosensitive elements R3 and R2 are connected in series between the power supply Vcc and the ground GND. A potential difference between a potential Va appearing at a connection point between the magnetosensitive elements R1 and R4 and a potential Vb appearing at a connection point between magnetosensitive elements R3 and R2 is used as an output signal ΔV (Va - Vb). As described above, the magnetosensitive elements R1 to R4 constitute a differential bridge circuit, and a change in the electrical resistance of the magnetosensitive elements R1 to R4 according to a magnetic flux density appears as the level of the output signal ΔV.

The output signal ΔV is supplied in common to operation amplifiers 141 and 142. A compensation current i1 output from the operation amplifier 141 is supplied to the compensation coil C1. In the present embodiment, a switch SW1 is connected in series to the compensation coil C1. Thus, during turn-on of the switch SW1, the compensation current i1 flows to the ground GND through the compensation coil C1, whereas, during turn-off of the switch SW1, the compensation current i1 does not flow through the compensation coil C1. When the compensation current i1 flows through the compensation coil C1, a canceling magnetic field is generated. Thus, when the output signal ΔV corresponding to the magnetic flux density of the detection-target magnetic field is generated, the corresponding compensation current i1 flows through the compensation coil C1 to generate a canceling magnetic field in the opposite direction, with the result that the detection-target magnetic field flowing through the magnetic field collecting body 110 is canceled. That is, the detection-target magnetic field is not applied to the magnetosensitive elements R1 to R4.

The turn-on/off of the switch SW1 is controlled by a control circuit 130. The control circuit 130 periodically turns on/off the switch SW1. The turn-on/off frequency for the switch SW1 is set sufficiently higher than the frequency of the detection-target magnetic field.

A compensation current i2 output from the operation amplifier 142 is supplied to the compensation coil C2. The compensation coil C2 is integrated in the sensor chip 100 in a manner as illustrated in FIGS. 2 and 4. When the compensation current i2 output from the operation amplifier 142 flows through the compensation coil C2, a canceling magnetic field is generated. Thus, when the output signal ΔV corresponding to the magnetic flux density of the detection-target magnetic field is generated, the corresponding compensation current i2 flows through the compensation coil C2 to generate a canceling magnetic field in the opposite direction, with the result that the detection-target magnetic field to be applied to the magnetosensitive elements R1 to R4 is canceled on the sensor chip 100. Then, the compensation current i2 is current-voltage converted by a resistor 143 to generate an output signal Vout, whereby the strength of the detection-target magnetic field can be detected. In this case, the resistor 143 constitutes a detection circuit for detecting the compensation current i2 flowing through the compensation coil C2.

As described above, the magnetic sensor 1 according to the present embodiment includes the two compensation coils C1 and C2. The compensation coil C1 distant from the magnetosensitive elements R1 to R4 acts to cancel the detection-target magnetic field flowing through the magnetic field collecting body 110, and the compensation coil C2 close to the magnetosensitive elements R1 to R4 cancels the detection-target magnetic field on the sensor chip 100. Since the compensation coil C1 is connected in series with the switch SW1 periodically turning on/off, the detection-target magnetic field flowing through the magnetic field collecting body 110 is not canceled during turn-off of the switch SW1, so that the detection-target magnetic field is applied to the magnetosensitive elements R1 to R4, and the corresponding output signal Vout is obtained; on the other hand, during turn-on of the switch SW1, the detection-target magnetic field flowing through the magnetic field collecting body 110 is canceled, so that the detection-target magnetic field is not applied to the magnetosensitive elements R1 to R4, with the result that the output signal Vout becomes substantially zero.

That is, the detection-target magnetic field to be applied is modulated by the on/off frequency of the switch SW1. Thus, even when the frequency of a weak magnetic field to be detected is low, 1/f noise is significantly reduced. Further, not the characteristics of the magnetosensitive elements R1 to R4, but the detection-target magnetic field is modulated, noise of the magnetosensitive elements R1 to R4 themselves is not modulated.

In addition, the amount of the compensation current i1 that needs to be made to flow through the compensation coil C1, which is the amount of current required for canceling the detection-target magnetic field, is significantly smaller than the amount of current required for magnetically saturating the magnetic field collecting body 110 or magnetosensitive elements R1 to R4. This reduces the amount of the compensation current i1 supplied from the operation amplifier 141, thereby not only reducing current consumption, but also suppressing heat generation due to the compensation current. Further, the compensation current i2 that generates the output signal Vout flows to the compensation coil C2 integrated in the sensor chip 100, so that the output signal Vout can be made higher in accuracy.

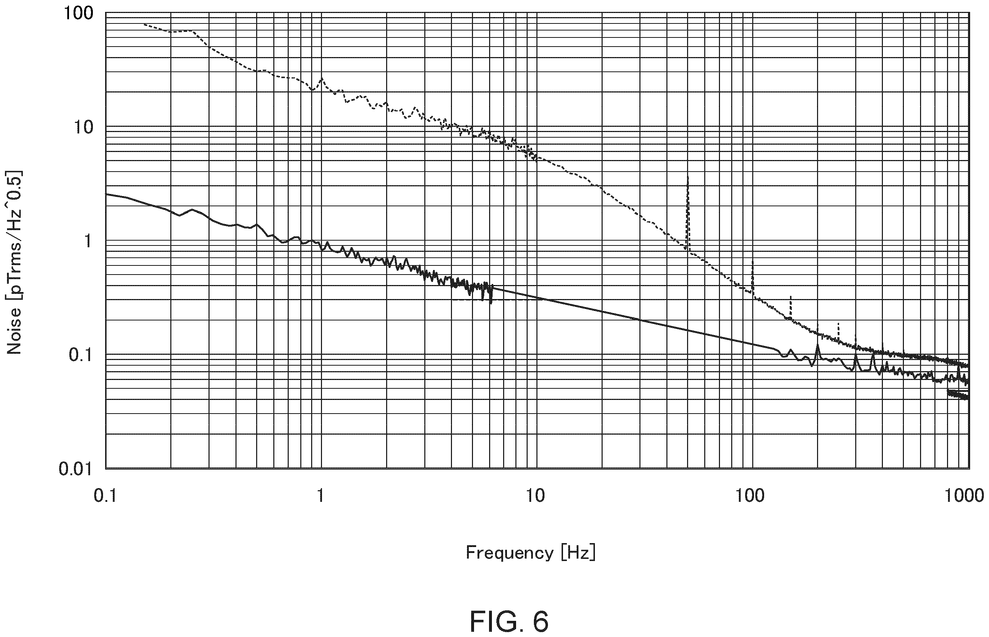

FIG. 6 is a graph for explaining the effect of the magnetic sensor 1 according to the present embodiment. In this graph, the solid line represents the frequency characteristics of noise in the magnetic sensor 1 according to the present embodiment, and the dashed line represents the frequency characteristics of noise in a conventional magnetic sensor not provided with the operation amplifier 141, compensation coil C1, and switch SW1. As can be seen from FIG. 6, in the magnetic sensor 1 according to the present embodiment, the detection-target magnetic field is modulated by the on/off frequency of the switch SW1, 1/f noise is significantly reduced particularly in a low frequency region.

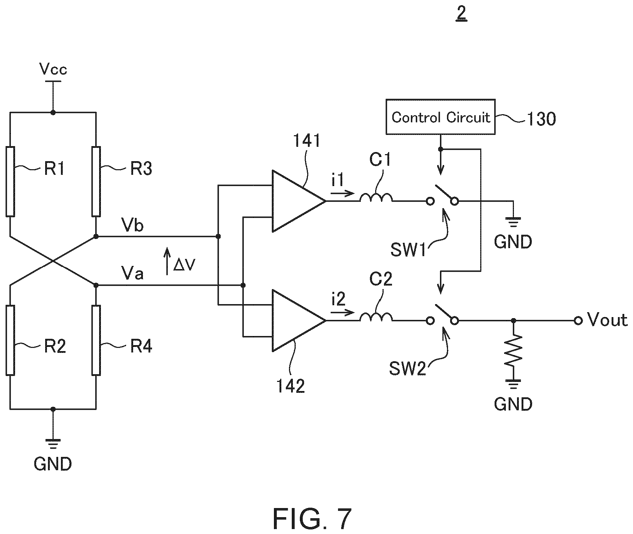

FIG. 7 is a circuit diagram of a magnetic sensor 2 according to a second embodiment of the present disclosure.

As illustrated in FIG. 7, the magnetic sensor 2 according to the second embodiment differs from the magnetic sensor 1 according to the first embodiment in that it further has a switch SW2 connected in series to the compensation coil C2. Other basic configurations are the same as those of the magnetic sensor 1 according to the first embodiment, so the same reference numerals are given to the same elements, and overlapping description will be omitted.

The turn-on/off of the switch SW2 is also controlled by the control circuit 130. The control circuit 130 turns on the switch SW2 while the switch SW1 is turned off and turns off the switch SW2 while the switch SW1 is turned on. That is, the output signal corresponding to the strength of the detection-target magnetic field can be obtained in a period during which the detection-target magnetic field can be detected by the magnetosensitive elements R1 to R4, whereas the output signal Vout is fixed to the ground level in a period during which the detection-target magnetic field is not applied to the magnetosensitive elements R1 to R4. As described above, in the magnetic sensor 2 according to the second embodiment, the output signal Vout can be set to the ground level without fail in a period during which the detection-target magnetic field flowing through the magnetic field collecting body 110 is canceled by the compensation coil C1.

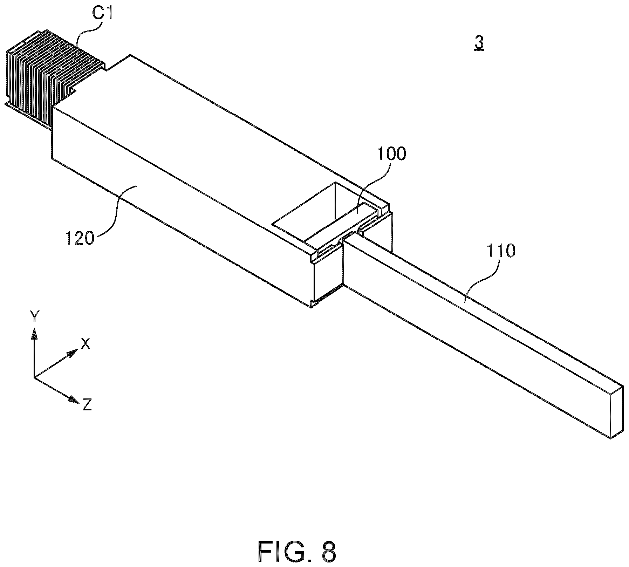

FIG. 8 is a schematic perspective view illustrating the outer appearance of a magnetic sensor 3 according to a third embodiment of the present disclosure.

As illustrated in FIG. 8, the magnetic sensor 3 according to the third embodiment differs from the magnetic sensor 1 according to the first embodiment in that the compensation coil C1 is wound around the magnetic field collecting body 120. Other basic configurations are the same as those of the magnetic sensor 1 according to the first embodiment, so the same reference numerals are given to the same elements, and overlapping description will be omitted.

As exemplified by the magnetic sensor 3 according to the third embodiment, in a case where the two magnetic field collecting bodies 110 and 120 are arranged so as to allow at least a part of the magnetic field that flows from one magnetic field collecting body (e.g., magnetic field collecting body 110) to the other magnetic field collecting body (e.g., magnetic field collecting body 120) to pass through the magnetosensitive elements R1 to R4, the compensation coil C1 may be wound around either one of the magnetic field collecting bodies 110 and 120. Alternatively, the compensation coil C1 may be wound around both of the magnetic field collecting bodies 110 and 120.

Further, even when the compensation coil C1 is wound around the magnetic field collecting body 120 as illustrated in FIG. 8, the switch SW2 configured to be turned on/off in conjunction with the turn-on/off of the switch SW1 may be connected in series to the compensation coil C2, as described using FIG. 7.

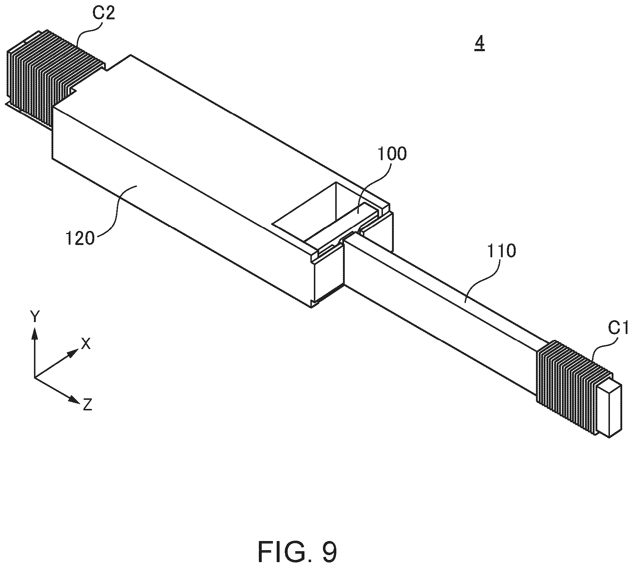

FIG. 9 is a schematic perspective view illustrating the outer appearance of a magnetic sensor 4 according to a fourth embodiment of the present disclosure.

As illustrated in FIG. 9, the magnetic sensor 4 according to the fourth embodiment differs from the magnetic sensor 1 according to the first embodiment in that the compensation coil C2 is wound around the magnetic field collecting body 120. Other basic configurations are the same as those of the magnetic sensor 1 according to the first embodiment, so the same reference numerals are given to the same elements, and overlapping description will be omitted.

In the present embodiment, the compensation coil C2 integrated in the sensor chip 100 is not necessary. Therefore, the sensor chip 100 may be configured not to have the compensation coil C2. Further, even when the sensor chip 100 has the compensation coil C2, the compensation current i2 is not supplied to the compensation coil C2 on the sensor chip 100. In the present embodiment, the compensation coil i2 is supplied to the compensation coil C2 wound around the magnetic field collecting body 120.

As exemplified by the magnetic sensor 4 according to the fourth embodiment, in a case where the two magnetic field collecting bodies 110 and 120 are arranged so as to allow at least a part of the magnetic field that flows from one magnetic field collecting body (e.g., magnetic field collecting body 110) to the other magnetic field collecting body (e.g., magnetic field collecting body 120) to pass through the magnetosensitive elements R1 to R4, the compensation coil C1 may be wound around one magnetic field collecting body, and the compensation coil C2 may be wound around the other magnetic field collecting body.

Further, in the present embodiment as well, the switch SW2 configured to be turned on/off in conjunction with the turn-on/off of the switch SW1 may be connected in series to the compensation coil C2, as described above using FIG. 7.

While some embodiments of the technology according to the present disclosure have been described, the technology according to the present disclosure is not limited to the above embodiments, and various modifications may be made within the scope of the present disclosure, and all such modifications are included in the technology according to the present disclosure.

The technology according to the present disclosure includes the following configuration examples, but not limited thereto.

A magnetic sensor according to an aspect of the present invention includes: a sensor chip having a magnetosensitive element; first and second compensation coils generating a canceling magnetic field based on an output signal from the magnetosensitive element; a first switch connected in series to the first compensation coil; a control circuit periodically turning on/off the first switch; and a detection circuit detecting a compensation current flowing through the second compensation coil. With this configuration, a detection-target magnetic field to be applied to the magnetosensitive element is modulated by the on/off frequency of the first switch, thus significantly reducing 1/f noise.

In the above magnetic sensor, the distance between the second compensation coil and the magnetosensitive element may be smaller than the distance between the first compensation coil and the magnetosensitive element. This can cancel the modulated detection-target magnetic field to be applied to the magnetosensitive element in the vicinity of the magnetosensitive element, so that higher sensitivity can be achieved.

The above magnetic sensor may further include a first magnetic field collecting body collecting a magnetic field to the magnetosensitive element, and the first compensation coil may be wound around the first magnetic field collecting body. This can modulate the detection-target magnetic field flowing through the first magnetic field collecting body.

In the above magnetic sensor, the second compensation coil may be integrated in the sensor chip. Thus, the modulated detection-target magnetic field on the sensor chip can be converted into an output signal by closed-loop control.

The above magnetic sensor may further include a second magnetic field collecting body collecting a magnetic field to the magnetosensitive element, the sensor chip may be disposed between the first and second magnetic field collecting bodies, and the second compensation coil may be wound around the second magnetic field collecting body. Thus, the modulated detection-target magnetic field on the second magnetic field collecting body can be converted into an output signal by closed-loop control.

The above magnetic sensor may further include a second switch connected in series to the second compensation coil, and the control circuit may turn on the second switch while the first switch is turned off and turn off the second switch while the first switch is turned on. This can fix the level of an output signal in a period during which the detection-target magnetic field is canceled.

## Claims

1. A magnetic sensor comprising:
a sensor chip having a magnetosensitive element;
first and second compensation coils configured to generate a canceling magnetic field based on an output signal from the magnetosensitive element;
a first switch connected in series to the first compensation coil;
a control circuit configured to periodically turn on/off the first switch; and
a detection circuit configured to detect a compensation current flowing through the second compensation coil.

2. The magnetic sensor as claimed in claim 1, wherein a distance between the second compensation coil and the magnetosensitive element is smaller than a distance between the first compensation coil and the magnetosensitive element.

3. The magnetic sensor as claimed in claim 1, further comprising a first magnetic field collecting body collecting a magnetic field to the magnetosensitive element,
wherein the first compensation coil is wound around the first magnetic field collecting body.

4. The magnetic sensor as claimed in claim 3, wherein the second compensation coil is integrated in the sensor chip.

5. The magnetic sensor as claimed in claim 2, further comprising a second magnetic field collecting body collecting a magnetic field to the magnetosensitive element,
wherein the sensor chip is disposed between the first and second magnetic field collecting bodies, and
wherein the second compensation coil is wound around the second magnetic field collecting body.

6. The magnetic sensor as claimed in any one of claims 1 to 5, further comprising a second switch connected in series to the second compensation coil,
wherein the control circuit is configured to turn on the second switch while the first switch is turned off and turn off the second switch while the first switch is turned on.
